# EUROPEAN PATENT APPLICATION

(11) **EP 4 190 950 A1**
(43) Date of publication of application: **07.06.2023**
(21) Application number: 22774001.6
(22) Date of filing: 01.03.2022
(51) Int. Cl.: C30B 29/06, C30B 15/00

(54) **FLOW GUIDE FOR MONOCRYSTAL FURNACE, MONOCRYSTAL FURNACE, AND METHOD FOR PROCESSING FLOW GUIDE**

(30) Priority: 25.03.2021 CN 202110320307
(71) Applicant: Xuzhou Xinjing Semiconductor Technology Co., Ltd., Xuzhou, Jiangsu 221004 (CN)
(72) Inventor: WANG, Shuangli, Xuzhou, Jiangsu 221004 (CN); CHEN, Chun-hung, Xuzhou, Jiangsu 221004 (CN)
(74) Representative: Grassi, Stefano
(86) International application number: PCT/CN2022/078641
(87) International publication number: WO 2022/199339

(57) **Abstract**

A reflector (1) for a monocrystal furnace (100), the monocrystal furnace (100), and a method for processing the reflector (1). The inner contour line of the reflector (1) comprises: a first straight line segment (11) extending in a vertical direction, a second straight line segment (13) having one end connected to the first straight line segment (11) and the other end extending obliquely upward, and a line segment group (14); the included angle α between the second straight line segment (13) and the vertical direction is greater than or equal to 45°; the line segment group (14) comprises a plurality of straight line segments which are sequentially connected and have different inclination angles, so as to transfer heat, transferred from a ingot (5) to the line segment group (14), towards a water cooling jacket (3).

## Description

### Cross-Reference to Related Application

The invention is based upon and claims priority to Chinese Patent Application No. 202110320307.X, filed on March 25, 2021, the invention of which is hereby incorporated by reference in its entirety.

### Technical Field

The invention relates to the technical field of monocrystal furnaces, in particular, to a reflector for the monocrystal furnace, the monocrystal furnace, and a method for processing the reflector.

### Background

When a silicon crystal grows, crystallization latent heat is generated near a solid-liquid interface. Generally, a reflector surrounding an ingot is disposed above the crystal, and a gas is allowed to enter a lifting area near the ingot along a inner side of the reflector, to purge the area, so as to take the crystallization latent heat away. As a diameter of a monocrystalline silicon bar increases, a temperature difference between the center and the outer side of the ingot becomes larger, resulting in difficult increasing of a crystallization rate and excessively-large heat stress inside the ingot. As a result, holes or misfit dislocation easily occur inside the ingot, affecting the processing quality of the ingot.

### Summary

The invention provides a reflector for a monocrystal furnace. The reflector for the monocrystal furnace may improve the processing quality of a ingot.

The invention further provides a monocrystal furnace. The monocrystal furnace includes the above reflector for the monocrystal furnace.

The invention further provides a method for processing a reflector. The processing method is used to process the above reflector for the monocrystal furnace.

According to the reflector for the monocrystal furnace in the embodiments of the invention, the monocrystal furnace includes a reflector, a furnace body, a water cooling jacket and a crucible. The reflector, the water cooling jacket and the crucible are all disposed in the furnace body. An ingot is formed in the crucible. The reflector and the water cooling jacket are both disposed around the ingot, and the water cooling jacket is located on an upper side of the reflector. A plane on which an axis section of the ingot is located is defined as a reference surface. The reflector is cut through the reference surface so as to form a section cutting plane. An inner contour line of the section cutting plane that is located on a side of the ingot includes: a first straight line segment, extending in a vertical direction, wherein an end of the first straight line segment that is adjacent to a liquid surface of the crucible is spaced apart from the liquid surface; a second straight line segment, wherein an end of the second straight line segment is connected with an end of the first straight line segment that faces away from the crucible, and the other end of the second straight line segment extends obliquely upward towards a direction facing away from the ingot, and an included angle between the second straight line segment and the vertical direction is α and meets: α≥45°; and a line segment group, including a plurality of straight line segments connected in sequence and with different inclination angles. An end of the line segment group is connected to the other end of the second straight line segment, and the other end of the line segment group extends obliquely upward towards a direction facing away from the ingot. The line segment group is configured to transfer heat, transferred from the ingot to the line segment group, towards the water cooling jacket. The water cooling jacket is used to prevent the heat from being reversely transferred to the ingot.

According to the reflector for the monocrystal furnace in the embodiments of the invention, by means of disposing the second straight line segment, when the heat on the ingot enters the second straight line segment in a radial direction of the ingot, since the included angle between the second straight line segment and the vertical direction is greater than or equal to 45°, the incident angle of the heat at this portion on the second straight line segment is also greater than or equal to 45°. According to the principle that an angle of reflection equals an incident angle, an included angle between the heat reflected by the second straight line segment and the incident heat is greater than or equal to 90°, so that the heat at this portion is able to be transferred, after being reflected, in a direction parallel to an outer wall surface of the ingot, or be transferred towards a direction facing away from an outer wall surface of the ingot. In this way, the heat at this portion is able to be prevented from being reflected back to the ingot. In addition, by means of disposing the line segment group, the heat is transferred from the ingot to the line segment group, and then is able to be transferred towards the water cooling jacket after being reflected by the line segment group. The water cooling jacket is used to prevent the heat from being reversely transferred to the ingot, so that the cooling of the ingot is able to be accelerated, facilitating the reduction of heat stress inside the ingot. Therefore, holes or misfit dislocation are able to be prevented from occurring inside the ingot, thereby improving the production quality of the ingot.

In some embodiments of the invention, in a radial direction of the ingot, an end of the second straight line segment that faces away from the ingot is flush with an outer edge of the water cooling jacket or is located on an outside of the outer edge of the water cooling jacket.

In some embodiments of the invention, the α meets: 50°≥α≥45°.

In some embodiments of the invention, two ends of the straight line segment are defined as an end A and an end B. An orthographic projection of the end A on the ingot is defined as C. The outer edge of the water cooling jacket in a radial direction is defined as D. An inner edge of the water cooling jacket in the radial direction is defined as E and meets: a line segment AB being perpendicular to angular bisector of ∠EAC, and a line segment AE being parallel to a line segment BD. The end A is an end of the straight line segment that is adjacent to the ingot.

In some embodiments of the invention, a number of the straight line segments included in the line segment group is X and meets: 30≥X≥10.

In some embodiments of the invention, in an axial direction of the ingot, a distance between an end of the first straight line segment adjacent to the liquid surface and the liquid surface is L and meets: 50 mm≥L≥20 mm.

In some embodiments of the invention, in a radial direction of the furnace body from inside to outside, the distance between a bottom surface of the reflector and the liquid surface gradually decreases; and an included angle between the bottom surface of the reflector and the liquid surface is β and meets: 8°≥β≥1°.

In some embodiments of the invention, the liquid surface and an inner peripheral wall of the crucible are formed as a first arc-shaped surface. A connection between a bottom wall of the reflector and an outer peripheral wall of the reflector is formed as a second arc-shaped surface that is disposed parallel to the first arc-shaped surface.

In some embodiments of the invention, the liquid surface and an outer peripheral wall of the ingot are formed as a third arc-shaped surface. A connection between a bottom wall of the reflector and an inner peripheral wall of the reflector is formed as a fourth arc-shaped surface that is disposed parallel to the third arc-shaped surface.

The monocrystal furnace according to the embodiments of the invention includes: a furnace body; a crucible, disposed in the furnace body and having a holding space, wherein an ingot is formed in the holding space; a water cooling jacket; and the above reflector for the monocrystal furnace. The reflector and the water cooling jacket are both disposed in the furnace body, and the water cooling jacket is located on an upper side of the reflector.

According to the monocrystal furnace in the embodiments of the invention, by means of disposing the second straight line segment, when the heat on the ingot enters the second straight line segment in a radial direction of the ingot, since the included angle between the second straight line segment and the vertical direction is greater than or equal to 45°, the incident angle of the heat at this portion on the second straight line segment is also greater than or equal to 45°. According to the principle that an angle of reflection equals an incident angle, an included angle between the heat reflected by the second straight line segment and the incident heat is greater than or equal to 90°, so that the heat at this portion is able to be transferred, after being reflected, in a direction parallel to an outer wall surface of the ingot, or be transferred towards a direction facing away from the outer wall surface of the ingot. In this way, the heat at this portion is able to be prevented from being reflected back to the ingot. In addition, by means of disposing the line segment group, the heat is transferred from the ingot to the line segment group, and then is able to be transferred towards the water cooling jacket after being reflected by the line segment group. The water cooling jacket is used to prevent the heat from being reversely transferred to the ingot, so that the cooling of the ingot is able to be accelerated, facilitating the reduction of heat stress inside the ingot. Therefore, holes or misfit dislocation are able to be prevented from occurring inside the ingot, thereby improving the production quality of the ingot.

In some embodiments of the invention, the water cooling jacket includes: a first connection portion, disposed around the ingot and extending in an axial direction of the ingot; and a second connection portion, connected with an end of the first connection portion that is adjacent to a liquid surface, and extending in a radial direction of the ingot.

In some embodiments of the invention, a surface on a side of the second connection portion that is adjacent to the liquid surface is formed as a first curved surface recessed towards the first connection portion.

In some embodiments of the invention, a surface on a side of the second connection portion that is adjacent to the ingot is formed as a second curved surface recessed towards a direction facing away from the ingot.

According to the method for processing a reflector in the embodiments of the invention, the reflector is the above reflector for the monocrystal furnace. A line segment group includes a plurality of straight line segments from straight line segment I to straight line segment N that are sequentially connected and have different inclination angles. An outer edge of the water cooling jacket in a radial direction is defined as D. An inner edge of the water cooling jacket in the radial direction is defined as E. The method for processing the reflector includes: processing the first straight line segment; and processing the second straight line segment. A starting point of the second straight line segment is an upper end point of the first straight line segment, and an end point of the second straight line segment is a point A1. The point A1 is flush with a point D of the water cooling jacket in a radial direction of the ingot.

The straight line segment I is processed. A starting point of the straight line segment I is A1, and an end point of the straight line segment I is B1. An orthographic projection of the point A1 on the ingot is a point C1. A step of processing the straight line segment I includes: using the point A1 as a starting point, to draw a first reference line that is obliquely-upward and perpendicular to angular bisector of ∠EA1C1; and translating EA1 to a position of the point D, and forming an intersection point B1 with the first reference line, wherein A1B1 is the straight line segment I.

The straight line segment II is processed. A starting point of the straight line segment II is A2. The point A2 coincides with the point B1 of the straight line segment I. An end point of the straight line segment II is B2. An orthographic projection of the point A2 on the ingot is a point C2. A step of processing the straight line segment II includes: using the point A2 as a starting point, to draw a second reference line that is obliquely-upward and perpendicular to angular bisector of ∠EA2C2; and translating EA2 to a position of the point D, and forming an intersection point B2 with the second reference line, wherein A2B2 is the straight line segment II.

The straight line segment III is processed. A starting point of the straight line segment III is A3. The point A3 coincides with the point B2 of the straight line segment II. An end point of the straight line segment III is B3. An orthographic projection of the point A3 on the ingot is a point C3. A step of processing the straight line segment III includes: using the point A3 as a starting point, to draw a third reference line that is obliquely-upward and perpendicular to angular bisector of ∠EA3C3; and translating EA3 to a position of the D point, and forming an intersection point B3 with the third reference line, wherein A3B3 is the straight line segment III.

And so on, the straight line segment N is finally processed. A starting point of the straight line segment N is An, and an end point of the straight line segment N is Bn. An orthographic projection of the An point on the ingot is a point Cn. A step of processing the straight line segment N includes: using the point An as a starting point, to draw a Nth reference line that is obliquely-upward and perpendicular to angular bisector of zEAnCn; and translating EAn to a position of the point D, and forming an intersection point Bn with the Nth reference line, wherein AnBn is the straight line segment N, and N meets: N > 3.

According to the method for processing a reflector in the embodiments of the invention, by means of disposing the second straight line segment, when the heat on the ingot enters the second straight line segment in a radial direction of the ingot, since the included angle between the second straight line segment and the vertical direction is greater than or equal to 45°, the incident angle of the heat at this portion on the second straight line segment is also greater than or equal to 45°. According to the principle that an angle of reflection equals an incident angle, an included angle between the heat reflected by the second straight line segment and the incident heat is greater than or equal to 90°, so that the heat at this portion is able to be transferred, after being reflected, in a direction parallel to an outer wall surface of the ingot, or be transferred towards a direction facing away from an outer wall surface of the ingot. In this way, the heat at this portion is able to be prevented from being reflected back to the ingot. In addition, by means of disposing the line segment group, the heat is transferred from the ingot to the line segment group, and then is able to be transferred to the water cooling jacket after being reflected by the line segment group. The water cooling jacket is used to prevent the heat from being reversely transferred to the ingot, so that the cooling of the ingot is able to be accelerated, facilitating the reduction of heat stress inside the ingot. Therefore, holes or misfit dislocation are able to be prevented from occurring inside the ingot, thereby improving the production quality of the ingot.

Additional aspects and advantages of the invention will be partially set forth in the following description, and in part will be apparent from the following description, or be learned by practice of the invention.

### Brief Description of the Drawings

Fig. 1 is a schematic structural diagram of a monocrystal furnace according to an embodiment of the invention.
Fig. 2 is a schematic diagram of a local structure of a monocrystal furnace according to an embodiment of the invention.
Fig. 3 is an enlarged view of a part M in Fig. 2.
Fig. 4 is a schematic diagram of a local structure of a monocrystal furnace according to an embodiment of the invention.
Fig. 5 is a schematic diagram of a local structure of a monocrystal furnace according to an embodiment of the invention.

In the drawings:
Monocrystal furnace 100,
Reflector 1, First straight line segment 11, Second straight line segment 13,
Line segment group 14, Straight line segment I 141, Straight line segment II 142, Straight line segment III 143, Straight line segment IV 144, Straight line segment V 145,
Second arc-shaped surface 15, Fourth arc-shaped surface 16,
Furnace body 2, Water cooling jacket 3, First connection portion 31, Second connection portion 32,
First curved surface 321, Second curved surface 322, Third curved surface 323,
Crucible 4, First arc-shaped surface 41, Third arc-shaped surface 42,
Ingot 5.

### Detailed Description of the Embodiments

Embodiments of the invention are described in detail below. Examples of the embodiments are shown in the accompanying drawings, wherein the same or similar reference numerals throughout the invention represent the same or similar elements or the elements having the same or similar functions. The embodiments described below with reference to the accompanying drawings are exemplary and are used to explain the invention, but should not be construed as limitations on the invention.

The following invention provides many different embodiments or examples for implementing different structures of the invention. In order to simplify the invention, components and settings of specific examples are described below. Definitely, the above are merely examples and are not intended to limit the invention. Furthermore, the invention may repeat reference numerals and/or letters in different examples. The repetition is for simplicity and clarity, which itself does not indicate a relationship between the embodiments and/or configurations discussed. In addition, examples of various specific processes and materials are provided in the invention, but person skilled in the art is able to recognize the applicability of other processes and/or the use of other materials.

A reflector 1 for a monocrystal furnace 100 according to the embodiments of the invention is described below with reference to the drawings. The monocrystal furnace 100 includes a reflector 1, a furnace body 2, a water cooling jacket 3 and a crucible 4. The reflector 1, the water cooling jacket 3 and the crucible 4 are all disposed in the furnace body 2. An ingot 5 is formed in the crucible 4. The reflector 1 and the water cooling jacket 3 are both disposed around the ingot 5, and the water cooling jacket 3 is located on an upper side of the reflector 1.

For example, in an example of the invention, the crucible 4 has a holding space and is configured to place a silicon raw material melted by means of heating into the holding space. The furnace body 2 is provided with a heater used for heating the crucible 4. Under the heating of the heater, the silicon raw material in the holding space is able to be melted into liquid silicon. The furnace body 2 is further provided with the reflector 1 and an argon gas tube. The argon gas tube passes through the top of the furnace body 2 to extend into the furnace body 2, and then passes through an argon gas channel that is formed by the reflector 1 and the ingot 5, so as to facilitate the growth of the ingot. The furnace body 2 is further provided with the water cooling jacket 3. The water cooling jacket 3 is disposed around the ingot 5 and is located on the upper side of the reflector 1. The water cooling jacket 3 is configured to absorb heat radiated from the ingot 5 and transfer the heat outwards. In this way, the heat dissipation efficiency of the ingot 5 is able to be enhanced.

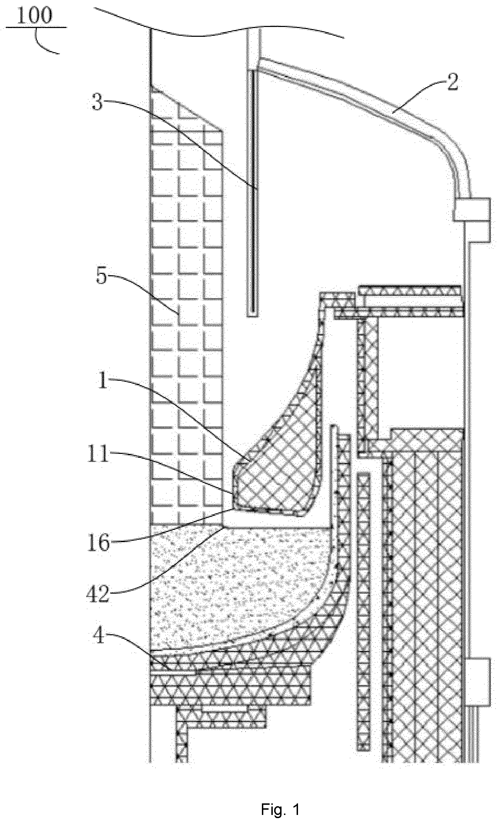

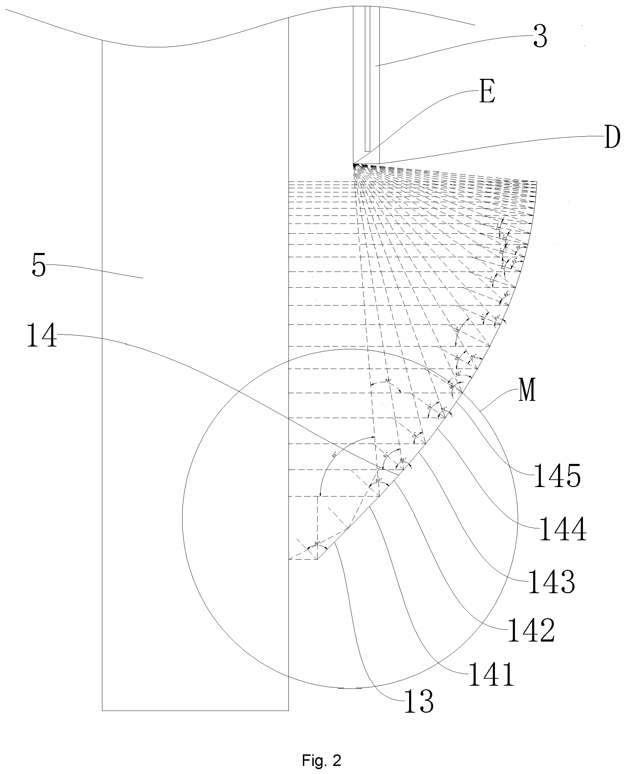

As shown in Fig. 1 and Fig. 2, a plane on which an axis section of the ingot 5 is located is defined as a reference surface. The reflector 1 is cut through the reference surface so as to form a section cutting plane. An inner contour line of the section cutting plane that is located on a side of the ingot 5 includes a first straight line segment 11, a second straight line segment 13 and a line segment group 14.

Specifically, as shown in Fig. 1, the first straight line segment 11 extends in a vertical direction, and an end of the first straight line segment 11 that is adjacent to a liquid surface of the crucible 4 is spaced apart from the liquid surface. Therefore, an argon gas flow channel is formed between a bottom end of the first straight line segment 11 and the liquid surface of the liquid silicon. The first straight line segment 11 is a straight line segment with a certain distance, so that an area that is close to the liquid surface is able to maintain a stable temperature gradient, so as to facilitate the growth of the ingot. It is to be noted that, a length of the first straight line segment 11 is required to be greater than or equal to a height of shoulder rotation of the ingot 5, and the height of the shoulder rotation of the ingot 5 is related to the growth diameter of the ingot 5. For example, in some embodiments of the invention, if an 8 inch ingot is grown, the length of the shoulder rotation is about 90 mm, and the length of the first straight line segment 11 is required to be greater than or equal to 90 mm. if a 12 inch ingot is grown, the length of the shoulder rotation is about 160 mm, and the length of the first straight line segment 11 is required to be greater than or equal to 160 mm.

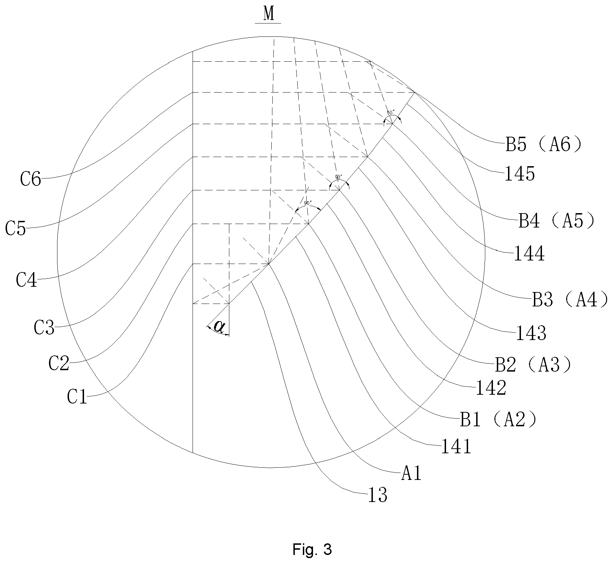

As shown in Fig. 2 and Fig. 3, an end of the second straight line segment 13 is connected with an end of the first straight line segment 11 that faces away from the crucible 4, and the other end of the second straight line segment 13 extends obliquely upward towards a direction facing away from the ingot 5. An included angle between the second straight line segment 13 and the vertical direction is α (which is α shown in Fig. 3) and meets: α≥45°. By disposing the second straight line segment 13, when the heat on the ingot 5 enters the second straight line segment 13 in a radial direction of the ingot 5, since the included angle between the second straight line segment 13 and the vertical direction is greater than or equal to 45°, the incident angle of the heat at this portion on the second straight line segment 13 is also greater than or equal to 45°. According to the principle that an angle of reflection equals an incident angle, an included angle between the heat reflected by the second straight line segment 13 and the incident heat is greater than or equal to 90°, so that the heat at this portion is able to be transferred, after being reflected, in a direction parallel to an outer wall surface of the ingot 5, or is able to be transferred towards a direction facing away from the outer wall surface of the ingot 5. In this way, the heat at this portion is able to be prevented from being reflected back to the ingot 5. In this way, the cooling of the ingot 5 is able to be accelerated, facilitating the reduction of heat stress inside the ingot 5. Therefore, holes or misfit dislocation are able to be prevented from occurring inside the ingot 5, thereby improving the production quality of the ingot 5.

Specifically, in some embodiments of the invention, the included angle between the second straight line segment 13 and the vertical direction may be 45°, 48°, 50°, 55°, 60°, or the like. The included angle between the second straight line segment 13 and the vertical direction is able to be selected and set according to the model and size of the monocrystal furnace 100.

For example, in an example of the invention, the included angle between the second straight line segment 13 and the vertical direction is 45°. When the heat on the ingot 5 enters the second straight line segment 13 in the radial direction of the ingot 5, the incident angle of the heat that is formed on the second straight line segment 13 is 45°. According to the principle that an angle of reflection equals an incident angle, the angle of reflection is also 45°. Since the second straight line segment 13 is disposed obliquely upward, the reflected heat is transferred upward vertically. That is to say, the reflected heat is transferred in the direction parallel to the outer wall surface of the ingot 5, so that the heat at this portion is able to be prevented from being reflected back to the ingot 5.

For another example, in another example of the invention, the included angle between the second straight line segment 13 and the vertical direction is 60°. When the heat on the ingot 5 enters the second straight line segment 13 in the radial direction of the ingot 5, the incident angle of the heat that is formed on the second straight line segment 13 is 60°. According to the principle that an angle of reflection equals an incident angle, the angle of reflection is also 60°. Since the second straight line segment 13 is disposed obliquely upward, the reflected heat is transferred obliquely upward and in the direction facing away from the ingot 5. That is to say, the reflected heat is transferred obliquely upward in the direction facing away from the ingot 5, so that the heat at this portion is able to be prevented from being reflected back to the ingot 5.

As shown in Fig. 2 and Fig. 3, the line segment group 14 includes a plurality of straight line segments that are sequentially connected and have different inclination angles. An end of the line segment group 14 is connected with the other end of the second straight line segment 13, and the other end of the line segment group 14 extends obliquely upward towards the direction facing away from the ingot 5. It is understandable that, the line segment group 14 includes the plurality of straight line segments, the plurality of straight line segments are sequentially connected. Each straight line segment extends obliquely upward towards the direction facing away from the ingot 5. For example, the line segment group 14 includes five straight line segments. The first strip straight line segment is connected with the second straight line segment 13; the second strip straight line segment is connected with the first strip straight line segment; the third strip straight line segment is connected with the second strip straight line segment; the fourth strip straight line segment is connected with the third strip straight line segment; and the fifth strip straight line segment is connected with the fourth strip straight line segment.

As shown in Fig. 1 to Fig. 3, the line segment group 14 is configured to transfer the heat, transferred from the ingot 5 to the line segment group 14, towards the water cooling jacket 3, and the water cooling jacket 3 is used to prevent the heat from being reversely transferred to the ingot 5. It is understandable that, the heat is transferred from the ingot 5 to the line segment group 14, and then is able to be transferred to the water cooling jacket 3 after being reflected by the line segment group 14. The water cooling jacket 3 is used to prevent the heat from being reversely transferred to the ingot 5, so that the cooling of the ingot 5 is able to be accelerated, facilitating the reduction of heat stress inside the ingot 5. Therefore, holes or misfit dislocation are able to be prevented from occurring inside the ingot 5, thereby improving the production quality of the ingot 5. In addition, since the cooling of the ingot 5 is able to be accelerated by disposing the second straight line segment 13 and the line segment group 14, the duration that the ingot 5 is at a heat dissipation phase during production is able to be reduced. Therefore, the production efficiency of the ingot 5 is able to be accelerated.

According to the reflector 1 for a monocrystal furnace 100 in the embodiments of the invention, by disposing the second straight line segment 13, when the heat on the ingot 5 enters the second straight line segment 13 in the radial direction of the ingot 5, since the included angle between the second straight line segment 13 and the vertical direction is greater than or equal to 45°, the incident angle of the heat at this portion on the second straight line segment 13 is also greater than or equal to 45°. According to the principle that an angle of reflection equals an incident angle, an included angle between the heat reflected by the second straight line segment 13 and the incident heat is greater than or equal to 90°, so that the heat at this portion is able to be transferred, after being reflected, in the direction parallel to the outer wall surface of the ingot 5, or is able to be transferred towards a direction facing away from the outer wall surface of the ingot 5. In this way, the heat at this portion is able to be prevented from being reflected back to the ingot 5. In addition, by disposing the line segment group 14, the heat is transferred from the ingot 5 to the line segment group 14, and then is able to be transferred to the water cooling jacket 3 after being reflected by the line segment group 14. The water cooling jacket 3 is used to prevent the heat from being reversely transferred to the ingot 5, so that the cooling of the ingot 5 is able to be accelerated, facilitating the reduction of heat stress inside the ingot 5. Therefore, holes or misfit dislocation are able to be prevented from occurring inside the ingot 5, thereby improving the production quality of the ingot 5.

In some embodiments of the invention, as shown in Fig. 1 to Fig. 3, in the radial direction of the ingot 5, an end of the second straight line segment 13 that faces away from the ingot 5 is flush with an outer edge of the water cooling jacket 3 or is located on the outside of an outer edge of the water cooling jacket 3. In other words, in the radial direction of the ingot 5, the end (that is, an upper end of the second straight line segment 13) of the second straight line segment 13 that faces away from the ingot 5 is able to be flush with the outer edge of the water cooling jacket 3; or in the radial direction of the ingot 5, the end of the second straight line segment 13 that faces away from the ingot 5 is able to be located on the outside of the outer edge of the water cooling jacket 3. Therefore, the heat reflected by the second straight line segment 13 is able to be reflected on the outer edge of the water cooling jacket 3 or reflected on the outside of the water cooling jacket 3. For example, in a specific example of the invention, in the radial direction of the ingot 5, the end of the second straight line segment 13 that faces away from the ingot 5 is flush with the outer edge of the water cooling jacket 3.

In some embodiments of the invention, as shown in Fig. 1 to Fig. 3, the α meets: 50°≥α≥45°. It is understandable that, by setting the included angle between the second straight line segment 13 and the vertical direction to be between 45° and 50°, on the basis of guaranteeing that the heat does not be transferred back to the ingot 5, a radius of the upper end of the second straight line segment 13 is able to be reduced, so that a size of the reflector 1 is able to be decreased, thereby reducing the space occupied by the reflector 1. For example, in some embodiments of the invention, the included angle between the second straight line segment 13 and the vertical direction is able to be 45°, 46°, 47°, 48°, 49°, or 50°.

In some embodiments of the invention, two ends of the straight line segment are defined as an end A and an end B. An orthographic projection of the end A on the ingot 5 is defined as C. The outer edge of the water cooling jacket 3 in the radial direction is defined as D. An inner edge of the water cooling jacket 3 in the radial direction is defined as E and meets: a line segment AB being perpendicular to angular bisector of ∠EAC, and a line segment AE being parallel to a line segment BD. The end A is an end of the straight line segment that is adjacent to the ingot 5.

It is understandable that, each straight line segment in the line segment group 14 is in accordance with the above situations. By the above arrangement, after the heat entering the straight line segment from the ingot 5 is reflected by the straight line segment, the heat is able to be reflected at E of the inner edge of the water cooling jacket 3. In this way, the heat is able to be blocked by the water cooling jacket 3, so that the heat is able to be effectively prevented from being transferred back to the ingot 5.

For example, for the heat at the point C of the ingot 5, the heat at this portion is able to be transferred to the end A of the straight line segment, and then is able to be transferred to the point E of the water cooling jacket 3 after being reflected at the end A. That is to say, it is able to be considered that CA is an incident path of the heat at this portion. Since the normal of an incident surface AB is the angular bisector of ∠EAC, a transfer path after the reflection of the line segment is AE. Therefore, the reflected heat is transferred to the inner edge of the water cooling jacket 3, so that the heat is able to be effectively prevented from being transferred back to the ingot 5. Since each straight line segment has the same feature, the heat reflected by each straight line segment is transferred to E of the inner edge of the water cooling jacket 3.

Specifically, in a specific example of the invention, the processes for processing the second straight line segment 13, and the straight line segment I 141, the straight line segment II 142, the straight line segment III 143, the straight line segment IV 144, ..., the straight line segment N of the line segment group 14 include the following steps.

Step one: the second straight line segment 13 is processed; a starting point of the second straight line segment 13 is an upper end point of the first straight line segment 11, and an end point of the second straight line segment 13 is a point A1; the point A1 is flush with the point D of the water cooling jacket 3 in the radial direction of the ingot 5; and the second straight line segment 13 extends obliquely outwards in a direction with an inclination angle being 45°.

Step two: the straight line segment I 141 is processed; a starting point of the straight line segment I 141 is A1, and an end point is B1; and an orthographic projection of the point A1 on the ingot 5 is a point C1. Specifically, the angular bisector of ∠EA1C1 is found firstly; by using the point A1 as a starting point, an obliquely-upward wall surface that is perpendicular to the angular bisector of ∠EA1C1 is made; and EA1 is translated to a position of the point D and forms an intersection point B1 with the wall surface, and A1B1 is the straight line segment I 141.

Step three: the straight line segment II 142 is processed; a starting point of the straight line segment II 142 is A2; the point A2 coincides with the point B1 in the straight line segment I 141; an end point of the straight line segment II 142 is B2; and an orthographic projection of the point A2 on the ingot 5 is a point C2. Specifically, the angular bisector of ∠EA2C2 is found firstly; by using the point A2 as a starting point, an obliquely-upward wall surface that is perpendicular to the angular bisector of ∠EA2C2 is made; and EA2 is translated to a position of the point D and forms an intersection point B2 with the wall surface, and A2B2 is the straight line segment II 142.

Step four: the straight line segment III 143 is processed; a starting point of the straight line segment III 143 is A3; the point A3 coincides with the point B2 in the straight line segment II 142; an end point of the straight line segment III 143 is B3; and an orthographic projection of the point A3 on the ingot 5 is a point C3. Specifically, the angular bisector of ∠EA3C3 is found firstly; by using the point A3 as a starting point, an obliquely-upward wall surface that is perpendicular to the angular bisector of ∠EA3C3 is made; and EA3 is translated to a position of the point D and forms an intersection point B3 with the wall surface, and A3B3 is the straight line segment III 143.

Step five: the straight line segment IV 144 is processed; a starting point of the straight line segment IV 144 is A4; the point A4 coincides with the point B3 in the straight line segment III 143; an end point of the straight line segment IV 144 is B4; and an orthographic projection of the point A4 on the ingot 5 is a point C4. Specifically, the angular bisector of ∠EA4C4 is found firstly; by using the point A4 as a starting point, an obliquely-upward wall surface that is perpendicular to the angular bisector of ∠EA4C4 is made; and EA4 is translated to a position of the point D and forms an intersection point B4 with the wall surface, and A4B4 is the straight line segment IV 144.

Step six: the straight line segment V 145 is processed; a starting point of the straight line segment V 145 is A5; the point A5 coincides with the point B4 in the straight line segment IV 144; an end point of the straight line segment V 145 is B5; and an orthographic projection of the point A5 on the ingot 5 is a point C5. Specifically, the angular bisector of ∠EA5C5 is found firstly; by using the point A5 as a starting point, an obliquely-upward wall surface that is perpendicular to the angular bisector of ∠EA5C5 is made; and EA5 is translated to a position of the point D and forms an intersection point B5 with the wall surface, and A5B5 is the straight line segment V 145.

Step seven: the straight line segment VI is processed; a starting point of the straight line segment VI is A6; the point A6 coincides with the point B5 in the straight line segment V 145; an end point of the straight line segment VI is B6; and an orthographic projection of the point A6 on the ingot 5 is a point C6. Specifically, the angular bisector of ∠EA6C6 is found firstly; by using the point A6 as a starting point, an obliquely-upward wall surface that is perpendicular to the angular bisector of ∠EA6C6 is made; and EA6 is translated to a position of the point D and forms an intersection point B6 with the wall surface, and A6B6 is the straight line segment VI.

And so on, assuming that the line segment group 14 includes 24 straight line segments, a step of processing the straight line segment XXIV includes the following.

A starting point of the straight line segment XXIV is A24; the point A24 coincides with a point B23 in the straight line segment XXIII; an end point of the straight line segment XXIV is B24; and an orthographic projection of the point A24 on the ingot 5 is a point C24. Specifically, the angular bisector of z EA24C24 is found firstly; by using the point A24 as a starting point, an obliquely-upward wall surface that is perpendicular to the angular bisector of ∠EA24C24 is made; and EA24 is translated to a position of the point D and forms an intersection point B24 with the wall surface, and A24B24 is the straight line segment XXIV.

In some embodiments of the invention, as shown in Fig. 1 to Fig. 3, a number of the straight line segments included in the line segment group 14 is X and meets: 30≥X≥10. It is understandable that, the number of the straight line segments is related to the size of the reflector 1, a relative position of the reflector 1 and the water cooling jacket 3, and a relative position of the reflector 1 and the ingot 5. By setting the number of the straight line segments to be between 10 and 30, number requirements in most cases are able to be met, so that the requirements of users are able to be better met. For example, in an example of the invention, the number of the straight line segment included in the line segment group 14 is 10, 12, 14, 16, 18, 20, 22, 24, 26, 28, or 30.

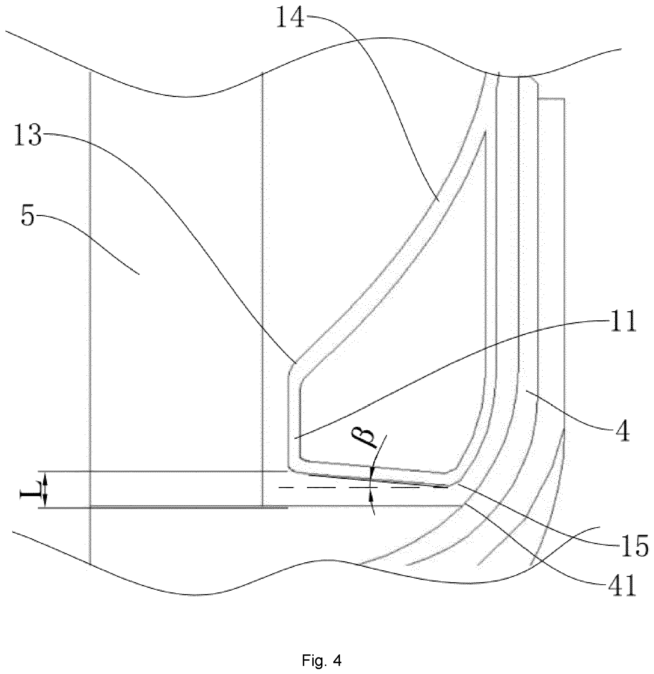

In some embodiments of the invention, as shown in Fig. 1 and Fig. 4, in an axial direction of the ingot 5, a distance between an end of the first straight line segment 11 adjacent to the liquid surface and the liquid surface is L (the L being shown in Fig. 4) and meets: 50 mm≥L≥20 mm. It is understandable that, during shoulder rotation of a seed crystal, a problem of line breaking easily occurs. By setting the distance between the end of the first straight line segment 11 adjacent to the liquid surface and the liquid surface to be between 20 mm and 50 mm, it is able to ensure that the temperature gradient at a position of this portion does not change, and airflow does not change too much, so that the problem of line breaking is able to be avoided.

For example, in an example of the invention, the process of processing the ingot 5 includes: putting a high-purity polysilicon raw material into the crucible 4 of the monocrystal furnace 100, and then melting the polysilicon raw material by means of heating under the protection of low vacuum with flowing inert gas; putting a piece of monocrystalline silicon (also called the seed crystal) with a specific growth direction into a seed crystal holding apparatus, and causing the seed crystal to come into contact with the silicon solution; adjusting the temperature of the molten silicon solution, so as to cause the temperature to approach a melting temperature; then driving the seed crystal to extend, from top to bottom, into the molten silicon solution and perform rotation; then slowly lifting the seed crystal, wherein in this case, the monocrystalline silicon entering a cone growth phase; when the diameter of the cone is close to a target diameter, accelerating the lifting speed of the seed crystal, to cause the diameter of the monocrystalline silicon body to be no longer increased so as to enter a middle growth phase of the crystal; and when the growth of the monocrystalline silicon body is nearly completed, accelerating the lifting speed of the seed crystal again, to cause the monocrystalline silicon body to be gradually separated from the molten silicon, so as to form a lower cone and end the growth.

Specifically, in some examples of the invention, in the axial direction of the ingot 5, the distance between the end of the first straight line segment 11 adjacent to the liquid surface and the liquid surface is 20 mm, 25 mm, 30 mm, 35 mm, 40 mm, 45 mm, or 50 mm.

In some embodiments of the invention, as shown in Fig. 1 and Fig. 4, in a radial direction of the furnace body 2 from inside to outside, a distance between a bottom surface of the reflector 1 and the liquid surface gradually decreases; and an included angle between the bottom surface of the reflector 1 and the liquid surface is β (the β being shown in Fig. 4) and meets: 8°≥β≥1°. It is understandable that, the temperature of a free liquid surface of the liquid silicon gradually increases with the decreasing of the distance from the wall of the crucible 4. As the temperature difference increases, Marangoni is enhanced accordingly, so that the transport of oxygen from the inner wall of the crucible 4 to a solid-liquid interface is accelerated, affecting the production quality of the ingot 5. In the invention, in the radial direction of the furnace body 2 from inside to outside, the distance between the bottom surface of the reflector 1 and the liquid surface gradually decreases, so that, when argon gas flows through a channel between the bottom surface of the reflector 1 and the liquid surface, the flow rate of the argon gas gradually increases. Therefore, the temperature close to the wall of the crucible 4 is reduced, thereby weakening heat convection and oxygen transport.

In some embodiments of the invention, as shown in Fig. 4, the liquid surface and an inner peripheral wall of the crucible 4 are formed as a first arc-shaped surface 41. A connection between a bottom wall of the reflector 1 and an outer peripheral wall of the reflector 1 is formed as a second arc-shaped surface 15 that is disposed parallel to the first arc-shaped surface 41. It is understandable that, by disposing the second arc-shaped surface 15 parallel to the first arc-shaped surface 41 at the connection between the bottom wall of the reflector 1 and the outer peripheral wall of the reflector 1, the flow resistance of the argon gas is able to be reduced, so that the flow rate of the argon gas is able to be accelerated, thereby weakening heat convection and oxygen transport.

In some embodiments of the invention, as shown in Fig. 1, the liquid surface and an outer peripheral wall of the ingot 5 are formed as a third arc-shaped surface 42. The connection between the bottom wall of the reflector 1 and an inner peripheral wall of the reflector 1 is formed as a fourth arc-shaped surface 16 that is disposed parallel to the third arc-shaped surface 42. It is understandable that, by disposing the fourth arc-shaped surface 16 parallel to the third arc-shaped surface 42 at the connection between the bottom wall of the reflector 1 and the inner peripheral wall of the reflector 1, the flow resistance of the argon gas is able to be reduced, so that the flow rate of the argon gas is able to be accelerated, thereby taking away more oxygen.

A monocrystal furnace 100 according to the embodiments of the invention is described below with reference to the drawings.

As shown in Fig. 1, the monocrystal furnace 100 according to the embodiments of the invention includes a furnace body 2, a crucible 4, a water cooling jacket 3 and a reflector 1. The crucible 4 is disposed in the furnace body 2 and has a holding space. An ingot 5 is formed in the holding space. The reflector 1 and the water cooling jacket 3 are both disposed in the furnace body 2, and the water cooling jacket 3 is located on an upper side of the reflector 1.

According to the monocrystal furnace 100 in the embodiments of the invention, by disposing the second straight line segment 13, when the heat on the ingot 5 enters the second straight line segment 13 in the radial direction of the ingot 5, since the included angle between the second straight line segment 13 and the vertical direction is greater than or equal to 45°, the incident angle of the heat at this portion on the second straight line segment 13 is also greater than or equal to 45°. According to the principle that an angle of reflection equals an incident angle, an included angle between the heat reflected by the second straight line segment 13 and the incident heat is greater than or equal to 90°, so that the heat at this portion is able to be transferred, after being reflected, in the direction parallel to the outer wall surface of the ingot 5, or is able to be transferred towards a direction facing away from the outer wall surface of the ingot 5. In this way, the heat at this portion is able to be prevented from being reflected back to the ingot 5. In addition, by disposing the line segment group 14, the heat is transferred from the ingot 5 to the line segment group 14, and then is able to be transferred to the water cooling jacket 3 after being reflected by the line segment group 14. The water cooling jacket 3 is used to prevent the heat from being reversely transferred to the ingot 5, so that the cooling of the ingot 5 is able to be accelerated, facilitating the reduction of heat stress inside the ingot 5. Therefore, holes or misfit dislocation are able to be prevented from occurring inside the ingot 5, thereby improving the production quality of the ingot 5.

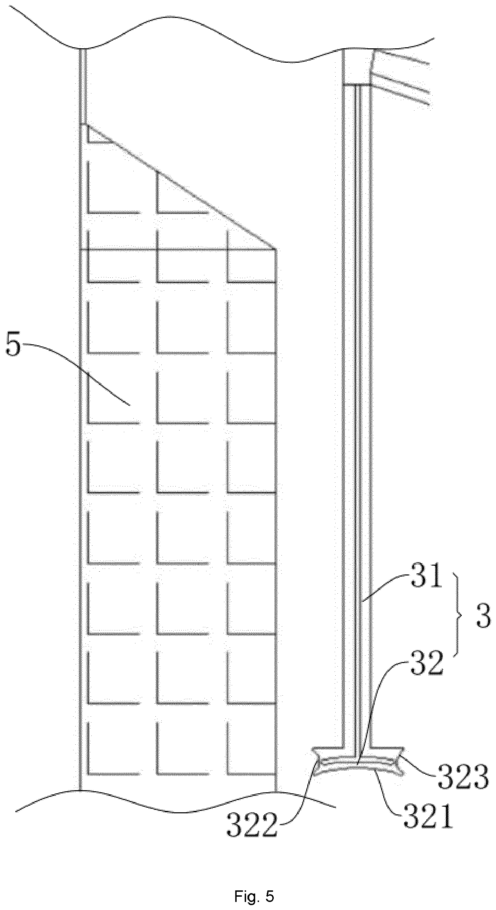

In some embodiments of the invention, as shown in Fig. 5, the water cooling jacket 3 includes a first connection portion 31 and a second connection portion 32. The first connection portion 31 is disposed around the ingot 5, and extends in the axial direction of the ingot 5. The second connection portion 32 is connected with an end of the first connection portion 31 adjacent to a liquid surface, and extends in the radial direction of the ingot 5. It is understandable that, a cross section of the water cooling jacket 3 located on the side of the ingot 5 is formed into an inverted T shape. By means of the above design, the width of a lower edge of the water cooling jacket 3 is able to be increased, so that more heat is able to be shielded by the lower edge of the water cooling jacket 3.

In some embodiments of the invention, as shown in Fig. 5, a surface on a side of the second connection portion 32 that is adjacent to the liquid surface is formed as a first curved surface 321 recessed towards the first connection portion 31. It is understandable that, by designing a bottom surface of the second connection portion 32 into a curved surface that is recessed towards the first connection portion 31, compared with a plane, the curved surface has the advantage of a large area, so that more reflected heat is able to be shielded and absorbed, thereby further enhancing the heat dissipation efficiency of the ingot 5.

In some embodiments of the invention, as shown in Fig. 5, the surface on a side of the second connection portion 32 that is adjacent to the ingot 5 is formed as a second curved surface 322 that is recessed towards the direction facing away from the ingot 5. It is understandable that, by designing the surface on a side of the second connection portion 32 that is adjacent to the ingot 5 into a curved surface that is recessed towards the direction facing away from the ingot 5, compared with the plane, the curved surface has the advantage of a large area, so that more heat on the ingot 5 is able to be radiated to the second curved surface 322, and more heat is able to be absorbed by using the water cooling jacket 3, thereby further enhancing the heat dissipation efficiency of the ingot 5. Specifically, in another example of the invention, the surface on a side of the second connection portion 32 that is facing away from the ingot 5 is formed as a third curved surface 323 that is recessed towards the ingot 5. It is apparent that the invention is not limited thereto. The surface on the side of the second connection portion 32 that is facing away from the ingot 5 is able to be a plane.

A method for processing a reflector 1 according to the embodiments of the invention is described below with reference to the drawings.

According to the method for processing a reflector 1 in the embodiments of the invention, the reflector 1 is the above reflector 1 for the monocrystal furnace 100. A line segment group 14 includes a plurality of straight line segments from straight line segments I 141 to straight line segment N connected in sequence and with different inclination angles. An outer edge of the water cooling jacket 3 in the radial direction is defined as D. An inner edge of the water cooling jacket 3 in the radial direction is defined as E. The method for processing the reflector 1 includes: processing the first straight line segment 11; and processing the second straight line segment 13. The starting point of the second straight line segment 13 is the upper end point of the first straight line segment 11, and the end point of the second straight line segment 13 is the point A1. The point A1 is flush with the point D of the water cooling jacket 3 in the radial direction of the ingot 5.

The straight line segment I 141 is processed. The starting point of the straight line segment I 141 is A1, and the end point of the straight line segment I 141 is B1. The orthographic projection of the point A1 on the ingot 5 is the point C1. The step of processing the straight line segment I 141 includes: using the point A1 as the starting point, to draw a first reference line that is obliquely-upward and perpendicular to angular bisector of ∠EA1C1; and translating EA1 to the position of the point D, and forming the intersection point B1 with the first reference line, wherein A1B1 is the straight line segment I 141.

The straight line segment II 142 is processed. The starting point of the straight line segment II 142 is A2. The point A2 coincides with the point B1 of the straight line segment I 141. The end point of the straight line segment II 142 is B2. The orthographic projection of the point A2 on the ingot 5 is the C2 point. The step of processing the straight line segment II 142 includes: using the point A2 as the starting point, to draw a second reference line that is obliquely-upward and perpendicular to angular bisector of ∠EA2C2; and translating EA2 to the position of the point D, and forming the intersection point B2 with the second reference line, wherein A2B2 is the straight line segment II 142.

The straight line segment III 143 is processed. The starting point of the straight line segment III 143 is A3. The point A3 coincides with the point B2 of the straight line segment II 142. The end point of the straight line segment III 143 is B3. The orthographic projection of the point A3 on the ingot 5 is the point C3. The step of processing the straight line segment III 143 includes: using the point A3 as the starting point, to draw a third reference line that is obliquely-upward and perpendicular to angular bisector of ∠EA3C3; and translating EA3 to the position of the D point, and forming the intersection point B3 with the third reference line, wherein A3B3 is the straight line segment III.

And so on, the straight line segment N is finally processed. A starting point of the straight line segment N is An, and an end point of the straight line segment N is Bn. The orthographic projection of the point An on the ingot is the point Cn. The step of processing the straight line segment N includes: using the point An as the starting point, to draw a Nth reference line that is obliquely-upward and perpendicular to angular bisector of ∠EAnCn; and translating EAn to the position of the point D, and forming the intersection point Bn with the Nth reference line, wherein AnBn is the straight line segment N, and N meets: N > 3.

For example, in a specific embodiment of the invention, the method for processing the reflector 1 includes the following steps.

Step one: the first straight line segment 11 is processed; the first straight line segment 11 extends in the vertical direction, and the end of the first straight line segment 11 that is adjacent to the liquid surface of the crucible 4 is spaced apart from the liquid surface.

Step two: the second straight line segment 13 is processed; the starting point of the second straight line segment 13 is the upper end point of the first straight line segment 11, and the end point of the second straight line segment 13 is the point A1; the point A1 is flush with the point D of the water cooling jacket 3 in the radial direction of the ingot 5; wherein the second straight line segment 13 extends obliquely outwards in the direction with an inclination angle being 45°.

Step three: the straight line segment I 141 is processed; the starting point of the straight line segment I 141 is A1, and the end point is B1; and the orthographic projection of the point A1 on the ingot 5 is the point C1. Specifically, the angular bisector of ∠EA1C1 is found firstly; by using the point A1 as the starting point, the obliquely-upward wall surface that is perpendicular to the angular bisector of ∠EA1C1 is made; and EA1 is translated to the position of the point D and forms the intersection point B1 with the wall surface, and A1B1 is the straight line segment I 141.

Step four: the straight line segment II 142 is processed; the starting point of the straight line segment II 142 is A2; the point A2 coincides with the point B1 in the straight line segment I 141; the end point of the straight line segment II 142 is B2; and the orthographic projection of the point A2 on the ingot 5 is the point C2. Specifically, the angular bisector of ∠EA2C2 is found firstly; by using the point A2 as the starting point, the obliquely-upward wall surface that is perpendicular to the angular bisector of ∠EA2C2 is made; and EA2 is translated to the position of the point D and forms the intersection point B2 with the wall surface, and A2B2 is the straight line segment II 142.

Step five: the straight line segment III 143 is processed; the starting point of the straight line segment III 143 is A3; the point A3 coincides with the point B2 in the straight line segment II 142; the end point of the straight line segment III 143 is B3; and the orthographic projection of the point A3 on the ingot 5 is the point C3. Specifically, the angular bisector of ∠EA3C3 is found firstly; by using the point A3 as the starting point, the obliquely-upward wall surface that is perpendicular to the angular bisector of ∠EA3C3 is made; and EA3 is translated to the position of the point D and forms the intersection point B3 with the wall surface, and A3B3 is the straight line segment III 143.

Step six: the straight line segment IV 144 is processed; the starting point of the straight line segment IV 144 is A4; the point A4 coincides with the point B3 in the straight line segment III 143; the end point of the straight line segment IV 144 is B4; and the orthographic projection of the point A4 on the ingot 5 is the point C4. Specifically, the angular bisector of ∠EA4C4 is found firstly; by using the point A4 as the starting point, the obliquely-upward wall surface that is perpendicular to the angular bisector of ∠EA4C4 is made; and EA4 is translated to the position of the point D and forms the intersection point B4 with the wall surface, and A4B4 is the straight line segment IV 144.

Step seven: the straight line segment V 145 is processed; the starting point of the straight line segment V 145 is A5; the point A5 coincides with the point B4 in the straight line segment IV 144; the end point of the straight line segment V 145 is B5; and the orthographic projection of the point A5 on the ingot 5 is the point C5. Specifically, the angular bisector of ∠EA5C5 is found firstly; by using the point A5 as the starting point, the obliquely-upward wall surface that is perpendicular to the angular bisector of ∠EA5C5 is made; and EA5 is translated to the position of the point D and forms the intersection point B5 with the wall surface, and A5B5 is the straight line segment V 145.

Step eight: the straight line segment VI is processed; the starting point of the straight line segment VI is A6; the point A6 coincides with the point B5 in the straight line segment V 145; the end point of the straight line segment VI is B6; and the orthographic projection of the point A6 on the ingot 5 is the point C6. Specifically, the angular bisector of ∠EA6C6 is found firstly; by using the point A6 as the starting point, the obliquely-upward wall surface that is perpendicular to the angular bisector of ∠EA6C6 is made; and EA6 is translated to the position of the point D and forms the intersection point B6 with the wall surface, and A6B6 is the straight line segment VI.

And so on, assuming that the line segment group 14 includes 24 straight line segments, the step of processing the straight line segment XXIV includes the following.

A starting point of the straight line segment XXIV is A24; the point A24 coincides with the point B23 in the straight line segment XXIII; the end point of the straight line segment XXIV is B24; and the orthographic projection of the point A24 on the ingot 5 is the point C24. Specifically, the angular bisector of z EA24C24 is found firstly; by using the point A24 as the starting point, the obliquely-upward wall surface that is perpendicular to the angular bisector of ∠EA24C24 is made; and EA24 is translated to the position of the point D and forms the intersection point B24 with the wall surface, and A24B24 is the straight line segment XXIV.

According to the method for processing a reflector 1 in the embodiments of the invention, by means of disposing the second straight line segment 13, when the heat on the ingot 5 enters the second straight line segment 13 in the radial direction of the ingot 5, since the included angle between the second straight line segment 13 and the vertical direction is greater than or equal to 45°, the incident angle of the heat at this portion on the second straight line segment 13 is also greater than or equal to 45°. According to the principle that an angle of reflection equals an incident angle, an included angle between the heat reflected by the second straight line segment 13 and the incident heat is greater than or equal to 90°, so that the heat at this portion is able to be transferred, after being reflected, in the direction parallel to the outer wall surface of the ingot 5, or is able to be transferred towards a direction facing away from the outer wall surface of the ingot 5. In this way, the heat at this portion is able to be prevented from being reflected back to the ingot 5. In addition, by means of disposing the line segment group 14, the heat is transferred from the ingot 5 to the line segment group 14, and then is able to be transferred to the water cooling jacket 3 after being reflected by the line segment group 14. The water cooling jacket 3 is used to prevent the heat from being reversely transferred to the ingot 5, so that the cooling of the ingot 5 is able to be accelerated, facilitating the reduction of heat stress inside the ingot 5. Therefore, holes or misfit dislocation are able to be prevented from occurring inside the ingot 5, thereby improving the production quality of the ingot 5.

In the invention, unless expressly specified and limited otherwise, the terms such as "mounting", "connected to each other", "connection" and "fixation" should be understood in a broad sense. For example, the term "connect" should be a fixed connection, a detachable connection, or an integrated; or should be a direct connection or an indirect connection by means of an intermediate medium; or should be an internal communication between two elements or an interaction relationship between two elements. For those of ordinary skill in the art, specific meanings of the above mentioned terms in the invention is able to be understood according to a specific condition.

In the description of the specification, descriptions of the terms "an embodiment," "some embodiments," "example," "specific example," or "some examples", mean that specific features, structures, materials, or characteristics described with reference to the implementations or examples are included in at least one implementation or example of the invention. In the specification, schematic representations of the above terms do not necessarily refer to the same embodiment or example. In addition, the described particular features, structures, materials or characteristics should be combined in any suitable manner in any one or more embodiments or examples. In addition, a person skilled in the art should integrate and combine the different embodiments or examples described in the specification and the features of the different embodiments or examples without contradiction.

Although the embodiments of the invention have been shown and described above, it should be understood by those skilled in the art that various changes, modifications, replacements and variations should be made in these embodiments without departing from the principle and objective of the invention, and the scope of the invention is defined by the claims and equivalents thereof.

## Claims

1. A reflector for a monocrystal furnace, wherein the monocrystal furnace comprises a reflector, a furnace body, a water cooling jacket and a crucible; the reflector, the water cooling jacket and the crucible are all disposed in the furnace body; a ingot is formed in the crucible; the reflector and the water cooling jacket are both disposed around the ingot, and the water cooling jacket is located on an upper side of the reflector; a plane on which an axis section of the ingot is located is defined as a reference surface; the reflector is cut through the reference surface so as to form a section cutting plane; and an inner contour line of the section cutting plane that is located on a side of the ingot comprises:
a first straight line segment, extending in a vertical direction, wherein an end of the first straight line segment that is adjacent to a liquid surface of the crucible is spaced apart from the liquid surface;
a second straight line segment, wherein an end of the second straight line segment is connected with an end of the first straight line segment that facing away from the crucible, and an other end of the second straight line segment extends obliquely upward towards a direction facing away from the ingot, and an included angle between the second straight line segment and the vertical direction is α and meets: α≥45°; and
a line segment group, comprising a plurality of straight line segments connected in sequence and with different inclination angles, wherein an end of the line segment group is connected with an other end of the second straight line segment, and the other end of the line segment group extends obliquely upward towards a direction facing away from the ingot; the line segment group is configured to transfer heat, transferred from the ingot to the line segment group, towards the water cooling jacket; and the water cooling jacket is used to prevent the heat from being reversely transferred to the ingot.

2. The reflector for the monocrystal furnace as claimed in claim 1, wherein in a radial direction of the ingot, an end of the second straight line segment that faces away from the ingot is flush with an outer edge of the water cooling jacket or is located on the outside of an outer edge of the water cooling jacket.

3. The reflector for the monocrystal furnace as claimed in claim 1, wherein the α meets: 50°≥α≥45°.

4. The reflector for the monocrystal furnace as claimed in claim 2, wherein two ends of the straight line segment are defined as an end A and an end B; an orthographic projection of the end A on the ingot is defined as C; the outer edge of the water cooling jacket in a radial direction is defined as D; an inner edge of the water cooling jacket in the radial direction is defined as E and meets: a line segment AB being perpendicular to angular bisector of ∠EAC, and a line segment AE being parallel to a line segment BD, wherein the end A is an end of the straight line segment that is adjacent to the ingot.

5. The reflector for the monocrystal furnace as claimed in claim 2, wherein a number of the straight line segments comprised in the line segment group is X and meets: 30≥X≥10.

6. The reflector for the monocrystal furnace as claimed in any of claims 1 to 5, wherein in an axial direction of the ingot, a distance between an end of the first straight line segment adjacent to the liquid surface and the liquid surface is L and meets: 50 mm≥L≥20 mm.

7. The reflector for the monocrystal furnace as claimed in any of claims 1 to 6, wherein in a radial direction of the furnace body from inside to outside, a distance between a bottom surface of the reflector and the liquid surface gradually decreases; and an included angle between the bottom surface of the reflector and the liquid surface is β and meets: 8°≥β≥1°.

8. The reflector for the monocrystal furnace as claimed in any of claims 1 to 7, wherein the liquid surface and an inner peripheral wall of the crucible are formed as a first arc-shaped surface; and a connection between a bottom wall of the reflector and an outer peripheral wall of the reflector is formed as a second arc-shaped surface that is disposed parallel to the first arc-shaped surface.

9. The reflector for the monocrystal furnace as claimed in any of claims 1 to 7, wherein the liquid surface and an outer peripheral wall of the ingot are formed as a third arc-shaped surface; and a connection between a bottom wall of the reflector and an inner peripheral wall of the reflector is formed as a fourth arc-shaped surface that is disposed parallel to the third arc-shaped surface.

10. A monocrystal furnace, comprising:
a furnace body;
a crucible, disposed in the furnace body and having a holding space, wherein a ingot is formed in the holding space;
a water cooling jacket; and the reflector for the monocrystal furnace as claimed in any of claims 1 to 9, wherein the reflector and the water cooling jacket are both disposed in the furnace body, and the water cooling jacket is located on an upper side of the reflector.

11. The monocrystal furnace as claimed in claim 10, wherein the water cooling jacket comprises:
a first connection portion, disposed around the ingot and extending in an axial direction of the ingot; and
a second connection portion, connected with an end of the first connection portion that is adjacent to a liquid surface, and extending in a radial direction of the ingot.

12. The monocrystal furnace according to claim 11, wherein a surface on a side of the second connection portion that is adjacent to the liquid surface is formed as a first curved surface recessed towards the first connection portion; or a surface on a side of the second connection portion that is adjacent to the ingot is formed as a second curved surface recessed towards a direction facing away from the ingot.

13. A method for processing a reflector, wherein the reflector is the reflector for the monocrystal furnace as claimed in any of claims 1 to 9; wherein the line segment group comprises a plurality of straight line segments from straight line segment I to straight line segment N that are sequentially connected and have different inclination angles; an outer edge of the water cooling jacket in a radial direction is defined as D, and an inner edge of the water cooling jacket in the radial direction is defined as E; and the method for processing the reflector comprises:
processing the first straight line segment;
processing the second straight line segment, wherein a starting point of the second straight line segment is an upper end point of the first straight line segment, an end point of the second straight line segment is a point A1, and the point A1 is flush with a point D of the water cooling jacket in a radial direction of the ingot;
processing the straight line segment I, wherein a starting point of the straight line segment I is A1, an end point of the straight line segment I is B1, an orthographic projection of the point A1 on the ingot is a point C1, and a step of processing the straight line segment I comprises:
using the point A1 as a starting point, to draw a first reference line that is obliquely-upward and perpendicular to angular bisector of ∠EA1C1; and
translating EA1 to a position of the point D, and forming an intersection point B1 with the first reference line, wherein A1B1 is the straight line segment I;
processing the straight line segment II, wherein a starting point of the straight line segment II is A2, the point A2 coincides with the point B1 of the straight line segment I, an end point of the straight line segment II is B2, an orthographic projection of the point A2 on the ingot is a point C2, and a step of processing the straight line segment II comprises:
using the point A2 as a starting point, to draw a second reference line that is obliquely-upward and perpendicular to angular bisector of ∠EA2C2; and
translating EA2 to a position of the point D, and forming an intersection point B2 with the second reference line, wherein A2B2 is the straight line segment II;
processing the straight line segment III, wherein a starting point of the straight line segment III is A3, the point A3 coincides with the point B2 of the straight line segment II, an end point of the straight line segment III is B3, an orthographic projection of the point A3 on the ingot is a point C3, and a step of processing the straight line segment III comprises:
using the point A3 as a starting point, to draw a third reference line that is obliquely-upward and
perpendicular to angular bisector of ∠EA3C3; and
translating EA3 to a position of the point D, and forming an intersection point B3 with the third reference line, wherein A3B3 is the straight line segment III,
and so on; and
finally processing the straight line segment N, wherein a starting point of the straight line segment N is An, an end point of the straight line segment N is Bn, an orthographic projection of the point An on the ingot is a point Cn, and a step of processing the straight line segment N comprises:
using the point An as a starting point, to draw a Nth reference line that is obliquely-upward and
perpendicular to angular bisector of zEAnCn; and
translating EAn to a position of the point D, and forming an intersection point Bn with the Nth reference line, wherein AnBn is the straight line segment N, wherein N meets: N >3.
